Europäisches Patentamt

European Patent Office

Office européen des brevets

(19)

(11) Publication number: **0 455 414 A1**

(12) **EUROPEAN PATENT APPLICATION**

(21) Application number: **91303714.9**

(22) Date of filing: **24.04.91**

(51) Int. Cl.⁵: **H01L 23/525**

(30) Priority: **30.04.90 US 515905**

(43) Date of publication of application:
**06.11.91 Bulletin 91/45**

(84) Designated Contracting States:
**DE ES FR GB**

(71) Applicant: **AMERICAN TELEPHONE AND TELEGRAPH COMPANY**
**550 Madison Avenue**
**New York, NY 10022 (US)**

(72) Inventor: **Lytle, Steven A.**
**1725 Jennings Street**
**Bethlehem, Pennsylvania 18017 (US)**

(74) Representative: **Watts, Christopher Malcolm Kelway et al**
**AT&T (UK) LTD. AT&T Intellectual Property Division 5 Mornington Road**
**Woodford Green Essex IG8 OTU (GB)**

(54) **Integrated circuits having antifuses.**

(57) An integrated circuit has electrically programmable antifuses comprising hydrogenated amorphous silicon(11) and a transition metal(5,15). The antifuse, which has a high OFF state resistance and a low ON state resistance, is useful in electrically programmable read only memories, programmable logic arrays, and other integrated circuits in which electrical circuits have to be selectively closed.

## FIG. 2

## Technical Field

This invention relates to integrated circuits having a plurality of electrically programmable antifuses.

## Background of the Invention

Present day semiconductor integrated circuits typically have hundreds of thousands of individual components. Due to the difficulty of making all of the individual circuit components on a chip with satisfactory characteristics, many integrated circuit chips, especially those with random access memories (RAM), are fabricated with redundant components. The redundant components are selectively included in the final circuit as replacements for defective components. This is presently a common practice in random access memory fabrication. The cost of fabricating the masks needed for pattern replication in integrated circuit manufacture is substantial, and some integrated circuits are made with a standard mask and then customized after completion of device fabrication. Such a customization process is commonly used in the fabrication of programmable logic arrays and many read-only memories. The former and latter are typically referred to as PLAs and ROMs, respectively. The former and latter are typically referred to as PLAs, RAMs, and ROMs, is the selective opening or closing of electrical circuits to produce the desired circuit.

One technique for closing an electrical circuit applies a voltage across a structure to change the structure from a high resistance state to a low resistance state when the voltage exceeds a treshold value. One such structure is described in United States Patent 4,442,507, issued on April 10, 1984, and uses a material having an electrically alterable resistance. The material is selected from the group consisting of elemental Si, Ge, C and alpha-Sn with either As or P present as a dopant at a concentration less than $10^{17}/cm^3$. To reduce the number of conductive paths through the material, it was stated that the material should have a grain size less than the grain size of the polycrystalline leads contacting the material. The structure was used in an electrically programmable read only memory. United States Patent 4,488,262, issued on December 11, 1984, describes an electrically programmable ROM having a bipolar transistor whose emitter region is at least partially overlaid with a dielectric. The dielectric, either an oxide or titanate of a transition metal, breaks down during programming, thereby forming an ohmic contact between the bit line and the emitter.

Another electrically programmable memory is described in United States Patent 4,499,557, issued on February 12, 1985. The memory uses amorphous silicon which may be deposited by any of several methods, including sputtering, plasma deposition, chemical vapor deposition, and electron beam evaporation. The amorphous silicon has well-known dopants, such as B or P, present in amounts between 0.1 and 5 percent, as well as H and F. The latter elements are present in amounts up to 10 atomic percent. Although the dopants increase the conductivity, and thus the OFF state leakage current, this conductivity increase is stated to be desirable because it facilitates both cell testing and use. It is further stated that the electrically induced transition from the high resistance OFF state to the low resistance ON state changes the amorphous silicon to a crystalline, conductive silicon; i.e., the ohmic heating caused by dielectric brakdown and subsequent current flow causes a phase change.

An n+ silicon/dielectric/polysilicon electrically programmable structure is analyzed in IEDM 1988, pp. 786-789, although the dielectric material used in the structure is never specified by the authors. The authors apply the term "antifuse" to the programmable structure because the current closes the circuit rather than opening it, as a fuse does; this term is now commonly used by those skilled in the art. An antifuse for bipolar ROMs is described in 1986 Bipolar Circuits and Technology Meeting, pp. 99-100. The antifuse used a layer of undoped amorphous silicon having metal layers on opposite sides of the amorphous silicon layer. The amorphous silicon deposition method is not explicitly described. If the metal layer comprised Al, a barrier layer was present between the silicon and the metal to prevent Al spiking. However, leakage currents through the antifuse as large as $10\mu$ amps at 2 volts were present in the current OFF state. This lekage did not seem to be a critical limitation for the bipolar ROM. However, for some applications, a higher OFF state resistance, and thus a lower leakage current, are desirable.

## Summary of the Invention

An integrated circuit comprising a plurality of devices; first and second pluralities of spaced apart electrically conducting sections, at least one of said electrically conducting sections of said first plurality electrically contacting at least one of said devices, at least one of said sections of said second plurality crossing over at least one of said sections of said first plurality at a crossover, said circuit having a plurality of said crossovers; a plurality of antifuses, with one antifuse per crossover, each antifuse comprising a layer comprising amorphous material selectedfrom the group consisting of Group IV elements and a resistivity increasing dopant; and a layer comprising dopant material between said layer of amorphous material and at lease one of said electrically conducting sections of said second plurality. In one embodiment, the resistivity increasing dopant is hydrogen present in an amount between 2 and 8 atomic percent.

In a preferred embodiment; the amorphous material comprises Si, which is desirably deposited by plasma enhanced chemical vapor deposition (PECVD). In another embodiment; the dopant material comprises at least one transition metal. In yet another preferred embodiment, the transition metal comprises Ti. In a further preferred embodiment, the antifuse further comprises at least one diffusion barrier layer between the silicon and at least one of the electrically conducting sections, which prevents diffusion of materials such as Al into or through the amorphous silicon. In a still further preferred embodiment; the diffusion barrier comprises Ti:W. The antifuse may be in its OFF state or may be programmed to its ON state. The resistance of ON state depends upon the polarity of the programming voltage when a single dopant layer is present. The device is typically a transistor, either field effect or bipolar. In yet another embodiment; the amorphous material comprises silicon having a resistivity of at least $50 \times 10^4$ ohm·cm.

## Brief Description of the Drawing

FG. 1 is a schematic depiction of an integrated circuit according to this invention having antifuses;
FG. 2 is a sectional view of a portion of an integrated circuit, including an anfuse; and,
FG. 3 is a current-voltage characteristic for an antifuse with the current plotted vertically in units of $\mu$ amps verses voltage plotted horizontally in units of volts.

For reasons of clarity, the elements depicted in the figures are not necessarily drawn to scale.

## Detailed Description

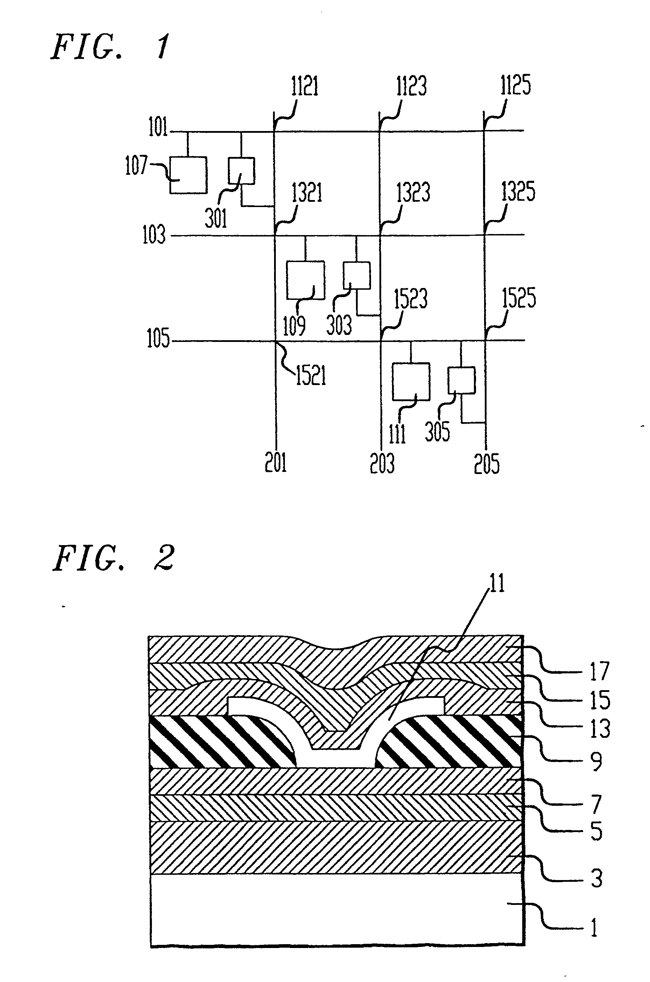

An exemplary integrated circuit having anises is schematically depicted in FIG. 1. Depicted are a first plurality spaced apart electrically conducting sections 101, 103, and 105 running horizontally and a second plurality of spaced apart electrically conducting sections 201, 203, and 205 running vertically. The sections of the first plurality are on a lower plane than are the sections of the second plurality, and the first and second plurality are separarated from each other by an intermediate dielectric layer (not shown). The sections of the first and second plurality have a plurality of crossover points as shown. Also depicted are antifuses 301, 303, and 305 between sections 101 and 201, 103 and 203, and 105 and 205, respectively. Antifuses 301, 303 and 305 are located at crossover points 1121, 1323 and 1525, respectively. Devices 107, 109, and 111 are electrically connected to sections 101, 103, and 105, respectively. The electrical contact to the devices is through electrical conductors. The devices will typically be a field-effect transistor, although the use of other types of devices, including bipolar transistor, is also contemplated. Of course, a typical circuit will have many more sections, antifuses, and devices. The limited number shown are, however, sufficient for purposes of explanation. The elements of such devices are well known to those skilled in the art and need not be depicted in detail. Device 107 may be electrically contacted from section 201 by changing antifuse 301 from its high resistance OFF state to its low resistance ON state. Many types of integrated circuits, including those in which antifuses are selectively changed to their low resistance ON state to program information into the circuit, are contemplated. Such circuits include electrically programmable read only memories (EPROMs) and programmable logic arrays (PLAs).

A sectional view of portion of an integrated circuit, according to this invention, having an antifuse is depicted in FIG. 2. The section of the circuit depicted comprises a via. Depicted are substrate 1, first electrically conducting section 3, first barrier layer 5, first dopant layer 7, dielectric layer 9, amorphous silicon layer 11, second dopant layer 13, second barrier layer 15, and second electrically conducting section 17. The first and second electrically conducting sections are part of the first and second pluralities, respectively. The first and second electrically conducting sections 3 and 17, respectively, are typically Al although other metals may be used. The electrically conducting sections electrically contact portions of the devices (not shown). The barrier layers 5 and 15 comprise a material which stops unwanted diffusion into the amorphous silicon layer or of amorphous silicon into the conducting layer. If such diffusion is not a problem, the barrier layers may be omitted. The first and second dopant layers 7 and 13 comprise a dopant material which reacts with the silicon to form an electrically conducting path through the amorphous silicon layer when a voltage at least as great as the treshold voltage is applied across the antifuse. The dopant material comprises at least one element selected from the group consisting of transition metals. Only a single dopant layer, typically the second layer, need be present to electrically change the antifuse to its low resistance ON state. The dielectric layer 9 is typically a silicon oxide which has been patterned to form a via as shown.

The primary constituent of layer 11 is an amorphous Group IV element, such as silicon, but the layer also has resistivity increasing dopant present. The increase in resistivity is measured from the resistivity of the undoped amorphous silicon. In an embodiment, the dopant is hydrogen, and it is present in an amount between 2 and 8 atomic percent hydrogen, i.e., layer 11 comprises amorphous silicon hydrogen. Amorphous silicon is preferred to polycrystalline silicon, as there are no conductive grain boundaries in amorphous silicon. The silicon is conveniently deposited by plasma-enhanced chemical vapor deposition and the hydrogen is incorporated into the layer during the deposition process. Those skilled in the art will readily select appropriate deposition parameters after reading this disclosure. The antifuse depicted has an OFF state resistance greater than $10^9$ ohms, which limits the leakage current to acceptably low levels, i.e., less than 1nA, for voltages typical of device operation and a 1μm diameter via. It is hypothesized that the presence of a resistivity-increasing dopant, such as hydrogen, is a primary factor in reducing the leakage current to acceptable levels because of the following. Many types of amorphous silicon, including sputtered silicon, typically have a significant number of dangling bonds, as not all sillicon atoms have nearest neighbors. The dangling bonds create midgap states which allow hopping conduction, thus permiting a silicant leakage current to be present. However, hydrogenated amorphous silicon has fewer dangling bonds than the sputtered, non-hydrogenated silicon has beause of the presence of the hydrogen. The smaller number of dangling bonds reduces the probability for hopping conduction to occur. Amounts of hydrogen greater than 8 atomic percent may result in greater conductivity than desired because the amount of hydrogen present is more than is needed to remove the dangling bonds. Conduction through the amorphous silicon layer by means of the hydrogen sites then becomes possible. Amounts of hydrogen less than 2 atomic percent leaves too many dangling bonds for the desired low-leakage current.

The structure depicted in FIG. 2 is fabricated by generally conventional techniques. There are, however, some points that merit explicit mention. Deposition and patterning of the dielectric layer is by methods well known to those skilled in the art. The amorphous silicon layer should be deposited at a relatively low temperature to prevent damage to the underlying Al layer, i.e., the first electrically conducting section. The damage could manifest itself as hillocking, voids, etc., which might adversely affect the characteristics of the Al layer. Although it is described as amorphous, the silicon layer may have some short range order. The term amorphous thus includes materials having a grain size smaller than the grain size of polycrystalline silicon. The silicon layer must have a grain structure which makes the layer highly resistive, i.e., the resistivity should be greater than $50 \times 10^4$ ohm-cm. The layer should also be nominally undoped, i.e., conventional n- and p-type dopants are not deliberately added. Methods for depositing amorphous, hydrogenated silicon are well known and those skilled in the art will readily select appropriate deposition parameters.

The two electrically conducting sections need not comprise metals. For example, the first electrically conducting section may comprise a doped or silicided polysilicon layer. This layer may also be a heavily doped single crystal silicon layer. The second electrically conducting section may also comprise, e.g., a doped or silicided polysilicon. It can, of course, also comprise Al.

The thicknesses of all layers except the dopant and amorphous silicon layers are determined by considerations well known to those skilled in the art and which therefore need not be described in detail. For example, the Ti:W diffusion barrier layers are approximately .1 μm thick in an exemplary embodimnt. The dopant layer in slightly thinner than in the amorphous silicon layer. The thickness of the amorphous silicon layer is dictated by the desired programmig voltages and the operating voltage between the conductors. That is, the latter condition determines the leakage current and provides a margin against unwanted closing of the antifuse during normal device operation. As the layer becomes thicker, the breakdown voltage becomes greater and the leakage current is reduced. An exemplary thickness is approximately 0.1μm.

The polarity of the applied voltage used to program the antifuse affects the final resistance of the antifuse when only one dopant layer is present. This is explained as follows. Assume that the dopant layer is between the amorphous silicon layer and the second electrically conducting section. A lower resistance for the antifuse is obtained when a posibve voltage is applied to the second electrically conducting section than when a negative voltage is applied to the same section. It is hypothesized that silicon atoms are moved into the Ti layer to form a silicide when a positive voltage is applied to the second electrically conducting section. However, when a negative voltage is applied to the second electrically conducting section, Ti atoms are moved into the silicon layer and there is little or not silicide formation. However, some polysilicon may be formed when the Ti atoms move into the amorphous silicon, thereby reducing the resistance from the value of the amorphous silicon.

It will be readily appreciated that; although the antifuse has been described in terms of a layer of amorphous silicon and one or two layers of dopant material, there may not be an abrupt interface between these layers but rather only a dopant rich portion, or portions, of amorphous silicon after programming. However, for reasons of exposition, it is believed that reference to discrete layers improves clarity.

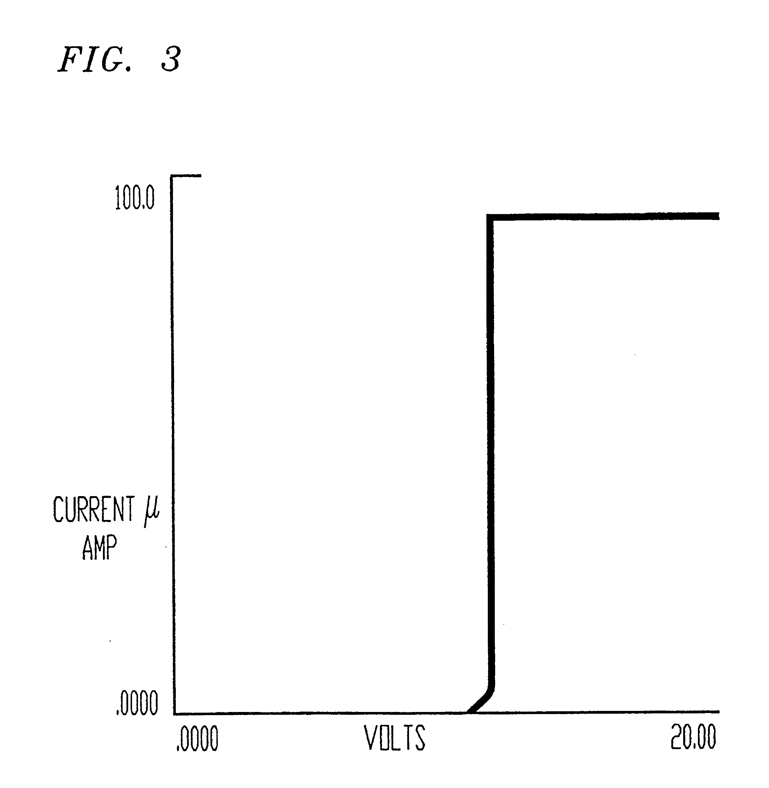

FIG. 3 shows the current-voltage characteristic curve for an antifuse with the current plotted vertically in units of μ amps versus the voltage plotted horizontally in units of volts. There was only a single layer of dopant material, Ti, which was between the layer of amorphous silicon and the second electrically conducting section. The antifuse was open before the curve was obtained, and the cureve was made during programming. As can be seen, the current is negligible, less than 1μ amp, until the programming voltage of about 11 volts is reached. At this value, the current rises abruptly to its closed circuit value, i.e., the ON state. To ensure programming of all antifuses, a voltage above threshold is desirably used to compensate for any variations in anises. Although the open circuit resistance depends in well-known manner on the size of the via, it was found that the closed circuit resistance is relatively independent of the via diameter. This indicates that the programming creates relatively localized current paths through the antifuse. This may impose a limitation on the current density in the via.

Variations to the embodiments described are contemplated. For example, contact antifuses may be fabricated. In this embodiment, the first electrically conducting section comprises an active region of a device. Additionally, other amorphous Group IV semiconductors, such as Ge and Sn, might be used. Furthermore, the dopant material might be adjacent to the first; rather than the second, electrically conducting section. The variation in ON state resistance, due to its polarty dependence, makes multi-level logic applications possible. Other resistivity increasing dopants, such as F, may also be used. The resistivity-increasing dopant may be omitted if the amorphous silicon has a resistivity of at least $50 \times 10^4$ ohm·cm.

## Claims

1.  An integrated circuit comprising a plurality of devices; first and second pluralities of spaced apart electrically conducting sections(3,17), at least one of said electrically conducting sections(3) of said first plurality electrically contacting at least one of said devices, at least one of said sections(17) of said second plurality crossing over at least one of said sections of said first plurality at a crossover, said circuit having a plurality of said crossover points; a plurality of antifuses, with one antifuse per crossover point each antifuse comprising a layer of amorphous material(11) comprising a Group IV element and a resistivity increasing dopant; a layer(7,13) comprising a first material comprising a dopant between said layer of amorphous material and one of said electrically conducting sections; and a barrier layer(5,15) comprising a second material between one of said electrically conducting sections and said layer of amorphous material.

2.  An integrated circuit as recited in claim 1 in which said Group IV element comprises Si.

3.  An integrated circuit as recited in claim 2 in which said resistivity increasing dopant is selected from the group consisting of H and F.

4.  An integrated circuit as recited in claims 3 in which said dopant is H and is present in the layer(11) in an amount between 2 and 8 atomic percent.

5.  An integrated circuit as recited in claim 2 in which said dopant material comprises at least one element selected from the group consisting of transition metals.

6.  An integrated circuit as recited in claim 5 in which said transition metal comprises Ti.

7.  An integrated circuit as recited in claim 2 in which at least one of said plurality of spaced apart electrically conducting sections(3,17) comprises aluminum.

8.  An integrated circuit as recited in claim 7 in which said barrier layer(5,15) comprises Ti and W.

9.  An integrated circuit as recited in claim 1 in which at least one of said antifuses is conductive.

10. An integrated circuit as recited in claim 10 in which said at least one of said antifuses has been made conductive by applying a voltage to said sections(3,17) of said first and second plurality with the voltage applied to said second plurality being positive.

11. An integrated circuit as recited in claim 10 in which said at least one of said antifuses has been rendered conductive by applying a voltage to said sections(3,17) of said first and second plurality with the voltage applied to said first plurality being positive with respect to the voltage applied to said second plurality.

## FIG. 1

## FIG. 2

# FIG. 3

European Patent
Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| D,A | GB-A-2 086 654 (ENERGY CONVERSION DEVICES)<br>* Abstract; page 5, line 18 - page 6, line 76 *<br>--- | 1-10 | H 01 L 23/525 |
| A | US-A-4 569 121 (LIM et al.)<br>* Abstract; column 6, line 43 - column 7, line 10 *<br>--- | 1-10 | |
| A | EP-A-0 036 802 (COMMISSARIAT A L'ENERGIE ATOMIQUE)<br>* Figure 1; page 4, line 4 - page 5, line 24 *<br>--- | 1 | |
| A | EP-A-0 323 078 (ACTEL CORP.)<br>* Abstract *<br>--- | 1 | |
| A | WO-A-8 702 827 (4C ELECTRONICS INC.)<br>* Figures 1,18; abstract; page 22, line 29 - page 24, line 15 *<br>--- | 1 | |
| P,A | EP-A-0 414 361 (ADVANCED MICRO DEVICES INC.)<br>* Abstract *<br>----- | 1 | TECHNICAL FIELDS SEARCHED (Int. Cl.5)<br><br>H 01 L |

The present search report has been drawn up for all claims

| Place of search | Date of completion of the search | Examiner |
|---|---|---|
| THE HAGUE | 01-08-1991 | GREENE S.K. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)